# EUROPEAN PATENT SPECIFICATION

(11) **EP 3 174 098 B1**
(45) Date of publication and mention of the grant of the patent: **30.10.2019**
(21) Application number: 16200474.1
(22) Date of filing: 24.11.2016
(51) Int. Cl.: H01L 27/12, H01L 27/32, H01L 51/52, H01L 51/56

(54) **THIN FILM TRANSISTOR SUBSTRATE FOR ORGANIC LIGHT EMITTING DIODE DISPLAY**
DÜNNSCHICHTTRANSISTORSUBSTRAT FÜR ORGANISCHE LICHTEMITTIERENDE DIODENANZEIGE
SUBSTRAT DE TRANSISTOR À FILM MINCE POUR DISPOSITIF D'AFFICHAGE À DIODES ÉLECTROLUMINESCENTES ORGANIQUES

(30) Priority: 26.11.2015 KR 20150166459
(43) Date of publication of application: 31.05.2017
(73) Proprietor: LG Display Co., Ltd., Seoul 07336 (KR)
(72) Inventor: OH, Kummi, 120-093 Seoul (KR); EOM, Hyeseon, 41803 Daegu (KR); YANG, Shunyoung, 420-758 Gyeonggi-do (KR); LEE, Jeounging, 152-766 Seoul (KR)
(74) Representative: Ter Meer Steinmeister & Partner

(56) References cited:
- US-A1- 2013 214 279
- US-A1- 2015 243 723

## Description

### BACKGROUND OF THE INVENTION

### Field of the Invention

The present disclosure relates to a thin film transistor substrate for an organic light emitting diode display having two different type thin film transistors on the same substrate, and a display using the same, as well as to a method for manufacturing the same.

### Discussion of the Related Art

Nowadays, as the information society is developed, the requirements of displays for representing information are increasing. Accordingly, various flat panel displays (or 'FPD') are developed for overcoming many drawbacks of the cathode ray tube (or 'CRT') which is heavy and bulky. The flat panel display devices include the liquid crystal display device (or 'LCD'), the plasma display panel (or 'PDP'), the organic light emitting display device (or 'OLED') and the electrophoresis display device (or 'ED').

The display panel of a flat panel display may include a thin film transistor substrate having a thin film transistor allocated in each pixel region arrayed in a matrix manner. For example, the liquid crystal display device (or 'LCD') displays images by controlling the light transmissivity of the liquid crystal layer using the electric fields. The OLED displays images by forming an organic light emitting diode at each pixel disposed in a matrix.

As a self-emitting display device, the organic light emitting diode display device (OLED) has the merits that the response speed is very fast, the brightness is very high and the view angle is large. The OLED using the organic light emitting diode having the good energy efficiencies can be categorized into the passive matrix type organic light emitting diode display (or PMOLED) and the active matrix type organic light emitting diode display (or AMOLED).

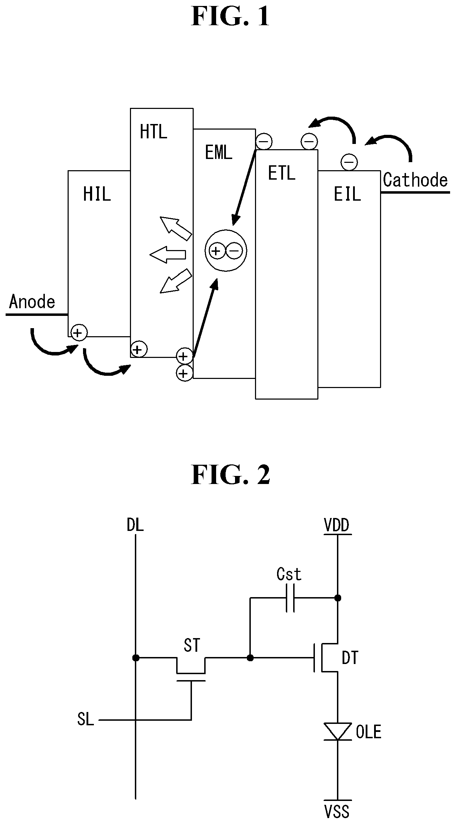

FIG. 1 is a diagram illustrating the structure of the organic light emitting diode. As shown in FIG. 1, the organic light emitting diode comprises the organic light emitting material layer, and the cathode and the anode which are facing each other with the organic light emitting material layer therebetween. The organic light emitting material layer comprises the hole injection layer HIL, the hole transport layer HTL, the emission layer EML, the electron transport layer ETL and the electron injection layer EIL. The organic light emitting diode radiates the lights due to the energy from the exciton formed at the excitation state in which the hole and the electron are recombined at the emission layer EML.

The organic light emitting diode radiates the lights due to the energy from the exciton formed at the excitation state in which the hole from the anode and the electron from the cathode are recombined at the emission layer EML. The organic light emitting diode display can represent the video data by controlling the amount (or 'brightness') of the light generated and radiated from the emission layer ELM of the organic light emitting diode as shown in FIG. 1.

The active matrix type organic light emitting diode display (or AMOLED) shows the video data by controlling the current applying to the organic light emitting diode using the thin film transistor (or TFT). FIG. 2 is the exemplary circuit diagram illustrating the structure of one pixel in the active matrix organic light emitting diode display (or AMOLED). FIG. 3 is a plane view illustrating the structure of one pixel in the AMOLED according to the related art. FIG. 4 is a cross sectional view along the cutting line I-I' for illustrating the structure of the AMOLED.

Referring to FIGs. 2 to 4, the active matrix organic light emitting diode display comprises a switching thin film transistor ST, a driving thin film transistor DT connected to the switching thin film transistor ST, and an organic light emitting diode OLE connected to the driving thin film transistor DT. The switching thin film transistor ST is formed where the scan line SL and the data line DL is crossing. The switching thin film transistor ST acts for selecting the pixel which is connected to the switching thin film transistor ST. The switching thin film transistor ST includes a gate electrode SG branching from the gate line GL, a semiconductor channel area SA overlapping with the gate electrode SG, a source electrode SS and a drain electrode SD.

The driving thin film transistor DT acts for driving an anode electrode ANO of the organic light emitting diode OLE disposed at the pixel selected by the switching thin film transistor ST. The driving thin film transistor DT includes a gate electrode DG connected to the drain electrode SD of the switching thin film transistor ST, a semiconductor channel area DA, a source electrode DS connected to the driving current line VDD, and a drain electrode DD. The drain electrode DD of the driving thin film transistor DT is connected to the anode electrode ANO of the organic light emitting diode OLE.

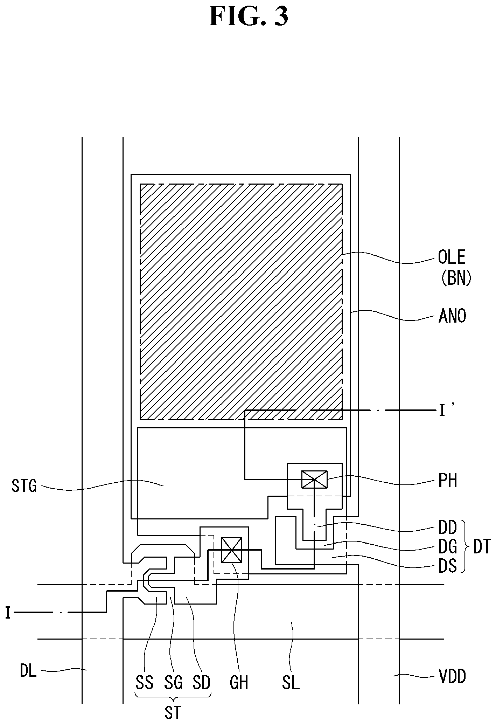

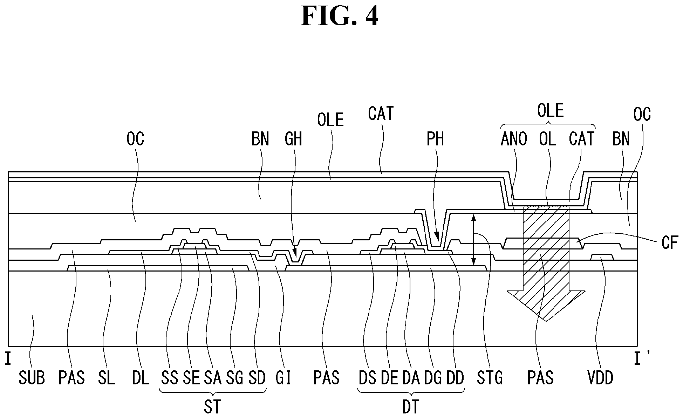

Referring to FIGs. 3 and 4 more detail, on the substrate SUB of the active matrix organic light emitting diode display, the gate electrodes SG and DG of the switching thin film transistor ST and the driving thin film transistor DT, respectively are formed. On the gate electrodes SG and DG, the gate insulator GI is deposited. On the gate insulator GI overlapping with the gate electrodes SG and DG, the semiconductor layers including channel areas SA and DA are formed, respectively. On the semiconductor layer, the source electrode SS and DS and the drain electrode SD and DD facing and separating from each other are formed. The drain electrode SD of the switching thin film transistor ST is connected to the gate electrode DG of the driving thin film transistor DT via a contact hole GH penetrating the gate insulator GI. The passivation layer PAS is deposited on the substrate SUB having the switching thin film transistor ST and the driving thin film transistor DT.

Especially, in the case that the semiconductor layers include the oxide semiconductor material, thanks to the characteristics of high electron mobility, it has merit for applied to a large area thin film transistor substrate having large charging capacitor. However, in order to ensure the stability of the oxide semiconductor material, it is preferable to include an etch stopper SE and DE covering the upper surface of channel area to protect them from etchants. In detail, the etch stoppers SE and DE would be formed to protect the channel areas SA and DA of the semiconductor layer from being back-etched by the etchant for patterning the source electrodes SS and DS and the drain electrodes SD and DD.

A color filer is formed at the area where the anode electrode ANO will be formed later. It is preferable for the color filter CF to have a large area as possible. For example, it is preferable to overlap with some portions of the data line DL, the driving current line VDD and/or the scan line SL. The upper surface of the substrate having these thin film transistors ST and DT and color filters CF is not in even and/or smooth conditions, but in uneven and/or rugged conditions having many steps. So, to make the upper surface in planar and even conditions, the over coat or planar layer OC is deposited on the whole surface of the substrate SUB.

Then, on the over coat layer OC, the anode electrode ANO of the organic light emitting diode OLE is formed. Here, the anode electrode ANO is connected to the drain electrode DD of the driving thin film transistor DT through a contact hole PH penetrating the over coat layer OC and the passivation layer PAS. A storage capacitance Cst is formed between the first storage electrode defined at the gate electrode of the driving thin film transistor DT and the second storage electrode defined at the source electrode of the driving thin film transistor DT. Otherwise the storage capacitance STG is formed between the gate electrode of the driving thin film transistor DT and the anode electrode ANO.

On the substrate SUB having the anode electrode ANO, a bank BN is formed over the area having the switching thin film transistor ST, the driving thin film transistor DT and the various lines DL, SL and VDD, for defining the light emitting area. The exposed portion of the anode electrode ANO by the bank BN would be the light emitting area.

On the anode electrode ANO exposed from the bank BN, the organic light emitting layer OL and the cathode electrode CAT are sequentially stacked. For the case that the organic light emitting layer OLE has a material emitting the white lights, each pixel can represent various colors by the color filter CF disposed under the anode electrode ANO. The organic light emitting diode display as shown in Fig. 4 is the bottom emission type display in which the visible light is radiated to the bottom direction of the display substrate. The cathode electrode CAT is applied with the ground level voltage from the low voltage supply line VSS.

For the organic light emitting diode display, the organic light emitting diode is operated using large current. Therefore it is preferable that the thin film transistor for driving the organic light emitting diode would have the large current driving characteristics. For example, the oxide semiconductor material is adaptable. Recently, as the needs for the high density organic light emitting diode display is increasing; the thin film transistor is required to have the characteristics for driving large current with less power consumption.

The oxide semiconductor material has a demerit of which characteristics are easily degraded by the lights induced from the environments. For the organic light emitting diode display, the lights generated at the organic light emitting layer may be introduced into the oxide semiconductor material. In that case, it is hard to keep the characteristics of the thin film transistor in best condition.

For the bottom gate structure as shown in FIG. 4, the gate metal is disposed at the bottom side of the oxide semiconductor material where the lights from the outside are intruding. Therefore, the gate metal can easily block the outside lights. However, in the bottom gate structure, the source electrode and the drain electrode directly contact the semiconductor layer. When forming the source and drain electrodes, the semiconductor layer has the 'Back Channel Etched (or BCE)' structure in which some thickness of the channel area is etched. With the BCE structure, it is very hard to ensure the reliability and/or stability of the semiconductor's characteristics.

Currently, a lot of products for the personal and portable information device are briskly developed, so that the display is developed as being adapted to portable or wearable devices. For portable or wearable devices, lower power consumption displays are required. With currently used technologies, it is hard to manufacture the display having lower power consumption specialized for the portable and/or wearable devices.
US 2013/214279 A1 describes a TFT substrate that includes a first TFT element having a hydrogenated amorphous silicon layer (a-Si:H) and gate, source, and drain electrodes. The TFT substrate includes a second TFT element having a semiconductor layer and gate, source, and drain electrodes. A gate insulating layer is formed on the gate electrodes. A passivation film is deposited over an entire surface of the TFT substrate.

### SUMMARY OF THE INVENTION

In order to overcome the above mentioned drawbacks, the purpose of the present disclosure is to suggest a thin film transistor substrate for an ultra high density organic light emitting diode display in which the characteristics of the channel area in the oxide semiconductor layer is maximized and optimized, and an organic light emitting display device including the same and a method for manufacturing the same. Another purpose of the present disclosure is to suggest a thin film transistor substrate having two different type thin film transistors on the same substrate in which the number of contact holes is reduced and/or minimized for accomplishing an organic light emitting diode display having the ultra high density and high aperture ratio, and an organic light emitting display device including the same and a method for manufacturing the same.

In order to accomplish the above purpose, the present disclosure suggests a thin film transistor substrate and an organic light emitting diode display using the same, including an oxide thin film transistor and a polycrystalline thin film transistor. The oxide thin film transistor has a top gate structure. The polycrystalline thin film transistor has a bottom gate structure. According to one example, the thin film transistor substrate comprises: a first thin film transistor including an oxide semiconductor layer, a first gate electrode on the oxide semiconductor layer, a first source electrode and a first drain electrode; a second thin film transistor including a second gate electrode, a polycrystalline semiconductor layer on the second gate electrode, a second source electrode and a second drain electrode; a first gate insulating layer disposed under the first gate electrode and the second gate electrode, and covering the oxide semiconductor layer; a second gate insulating layer disposed under the polycrystalline semiconductor layer, and covering the first gate electrode and the second gate electrode; and an intermediate insulating layer disposed on the first gate electrode and the polycrystalline semiconductor layer, and having a nitride layer including hydrogen. The thin film transistor substrate may include a pixel area disposed on a substrate and including a plurality of pixels. Further, the thin film transistor substrate may include a non-display area surrounding a display area. The first thin film transistor may be disposed in the non-display area, and the second thin film transistor may be disposed in the display area. Alternatively, at least one of the first and second thin film transistor may be disposed in the display area. Also, both the first and the second thin film transistor may be disposed in one pixel of the pixel area. Generally, throughout this specification, terms such as "disposed on", "below", "under", "between" is to be understood in a direction perpendicular to a surface of the thin film transistor substrate, i.e. vertical to the display area.

In one embodiment, the intermediate insulating layer further includes: an oxide layer under the nitride layer, i.e. the intermediate insulating layer may include an oxide layer between the layer of the first gate electrode and the nitride layer.

In one embodiment, the second gate electrode is overlapped with some portions of a drain area of the oxide semiconductor layer having the first gate insulating layer there-between. Preferably, the first source electrode is disposed on the intermediate insulating layer, and is in contact with one side of the oxide semiconductor layer via a first source contact hole penetrating the intermediate insulating layer, the second gate insulating layer and the first gate insulating layer. Preferably, the first drain electrode is disposed on the intermediate insulating layer, and is in contact with the other side of the oxide semiconductor layer via a first drain contact hole penetrating the intermediate insulating layer, the second gate insulating layer and the first gate insulating layer.

In one embodiment, the second source electrode is disposed on the intermediate insulating layer, and in contact with one side of the polycrystalline semiconductor layer via a second source contact hole penetrating the intermediate insulating layer. Preferably, the second drain electrode is disposed on the intermediate insulating layer, and in contact with the other side of the polycrystalline semiconductor layer via a second drain contact hole penetrating the intermediate insulating layer.

In one embodiment, the second source electrode is disposed on the intermediate insulating layer, and in contact with a first etched wall of one side of the polycrystalline semiconductor layer via a second source contact hole penetrating the intermediate insulating layer, the one side of the polycrystalline semiconductor layer and the second gate insulating layer. Preferably, the second drain electrode is disposed on the intermediate insulating layer, and in contact with a second etched wall of other side of the polycrystalline semiconductor layer via a second drain contact hole penetrating the intermediate insulating layer, the other side of the polycrystalline semiconductor layer and the second gate insulating layer.

In one embodiment, the first thin film transistor is a switching eletment for selecting a pixel of the thin film transistor substrate. Preferably, the second thin film transistor is a driving element for driving an organic light emitting diode disposed in the pixel selected by the first thin film transistor.

In one embodiment, the thin film transistor substrate further comprises: a planar layer covering the first thin film transistor and the second thin film transistor; a pixel contact hole formed at the planar layer, and exposing the second drain electrode; and an anode electrode disposed on the planar layer, and connected to the second drain electrode via the pixel contact hole. Further, the thin film transistor substrate may comprise: a bank defining an aperture area exposing an emitting area of the anode electrode; an organic light emitting layer disposed on the bank, and contacting the anode electrode in the aperture area; and a cathode electrode disposed on the organic light emitting layer.

According to another embodiment, an organic light emitting diode display including a substrate according to any one of the above described embodiments or combinations thereof is provided.

According to another embodiment, a method for manufacturing a thin film transistor substrate for an organic light emitting diode display is provided, the method including the steps of: forming (S110) an oxide semiconductor layer on a substrate (SUB); forming (S200) a first gate insulating layer (GI1) on the oxide semiconductor layer; forming (S210) a first gate electrode (SG) of a first thin film transistor (ST) and a second gate electrode (DG) of a second thin film transistor (DT) on the first gate insulating layer (GI1), the first gate electrode (SG) being disposed overlapping with the oxide semiconductor layer; forming (S300) a second gate insulating layer (GI2) on the first gate electrode (SG) and the second gate electrode (DG); forming (S310) a polycrystalline semiconductor layer on the second gate insulating layer (GI2), the polycrystalline semiconductor layer being disposed overlapping with the second gate electrode (DG); forming (S400) an intermediate insulating layer (ILD) including a nitride layer (SIN) including hydrogen on the polycrystalline semiconductor layer and on the second gate insulating layer (GI2); and forming (S500) first and second source electrodes (SS, DS) and first and second drain electrodes (SD, DD) on the intermediate insulating layer (ILD), whereby the first thin film transistor (ST) including the oxide semiconductor layer, the first gate electrode (SG) on the oxide semiconductor layer, the first source electrode (SS) and the first drain electrode (SD), and the second thin film transistor (DT) including the second gate electrode (DG), the polycrystalline semiconductor layer on the second gate electrode (DG), the second source electrode (DS) and the second drain electrode (DD) are formed. Preferably, the method further comprises the step of forming (S410) at least one contact hole including at least one of: a first source contact hole (SSH) penetrating the intermediate insulating layer (ILD), the second gate insulating layer (GI2) and the first gate insulating layer (GI1) for connecting the first source electrode (SS) and a source area (SSA) of the oxide semiconductor layer; a first drain contact hole (SDH) penetrating the intermediate insulating layer (ILD), the second gate insulating layer (GI2) and the first gate insulating layer (GI1) for connecting the first drain electrode (SD), a drain area (SDA) of the oxide semiconductor layer and the second gate electrode (DG) with each other; and a second source contact hole (DSH) penetrating the intermediate insulating layer (ILD), the polycrystalline semiconductor layer and the second gate insulating layer (GI2) for connecting the second source electrode (DS) and a source area (DSA) of the polycrystalline semiconductor layer. Preferably, the method comprises the steps of: forming (S410) a second drain contact hole (DDH) penetrating the intermediate insulating layer (ILD), the polycrystalline semiconductor layer and the second gate insulating layer (GI2) for connecting the second drain electrode (DD) and a drain area (DDA) of the polycrystalline semiconductor layer; forming (S600) a planar layer (OC) on the first and second source electrode (SS, DS) and on the first and second drain electrode (SD, DD); and forming (S610) a pixel contact hole (PH) in the planar layer (OC) disposed in the second drain contact hole (DDH) for exposing the second drain electrode (DD).

Clearly, all these preferred features and embodiments can be freely combined with each other. The thin film transistor substrate for an organic light emitting diode display according to the present disclosure has the demerit that any one type thin film transistor can be compensated by the other type thin film transistor. Especially, including the thin film transistor having the low off-current characteristics, the display can have the low frequency driving property and the low power consumption property. Further, the number of the contact holes included into the thin film transistor substrate for the organic light emitting diode display is minimized so that the ultra high density display with high aperture ratio can be suggested.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

### In the drawings:

FIG. 1 is a diagram illustrating the structure of the organic light emitting diode according to the related art.
FIG. 2 is the exemplary circuit diagram illustrating the structure of one pixel in the active matrix organic light emitting diode display (or AMOLED) according to the related art.
FIG. 3 is a plane view illustrating the structure of one pixel in the AMOLED according to the related art.
FIG. 4 is a cross sectional view along the cutting line I-I' for illustrating the structure of the AMOLED according to the related art.

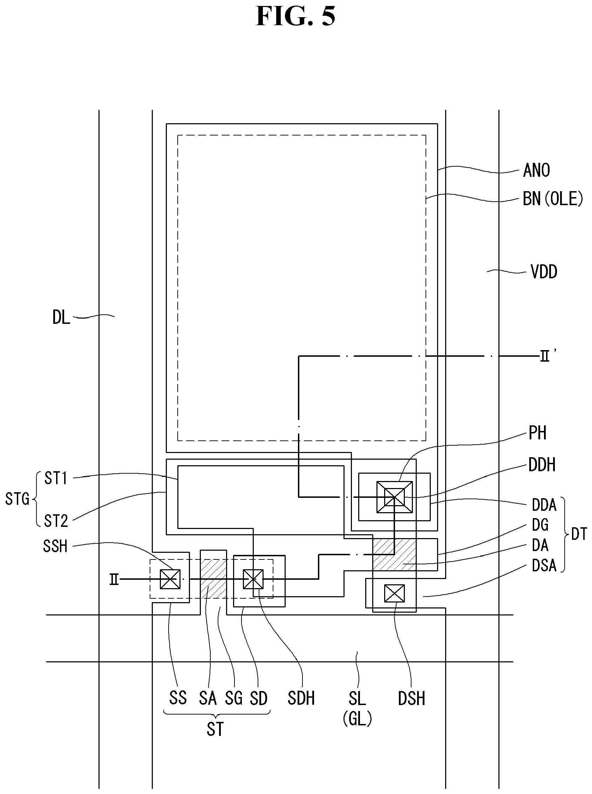

FIG. 5 is a plane view illustrating a structure of one pixel in the organic light emitting diode display according to a preferred embodiment of the present disclosure.

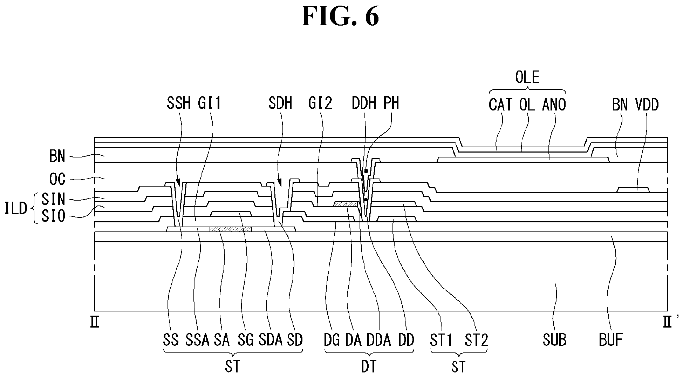

FIG. 6 is a cross sectional view along the cutting line of II-II' in FIG. 5 for illustrating the structure of an organic light emitting diode display according to the preferred embodiment of the present disclosure.

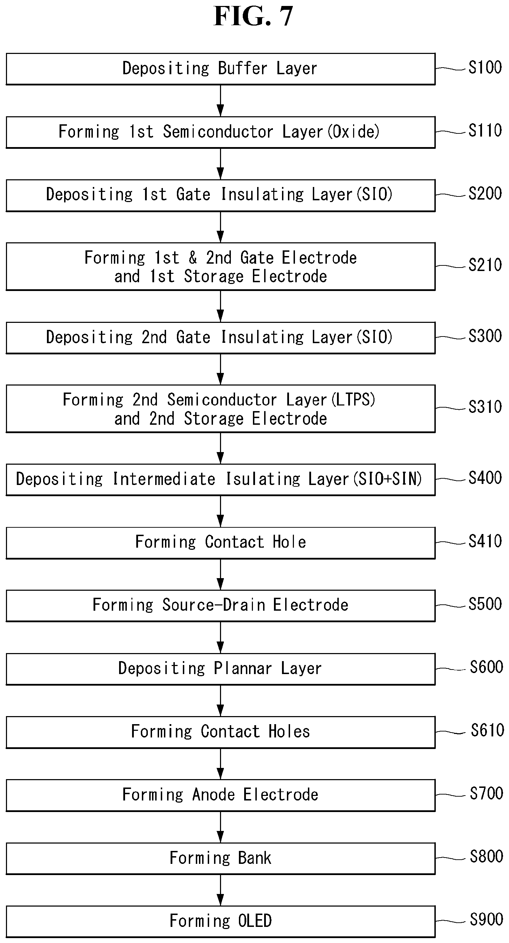

FIG. 7 is a flow chart illustrating a method for manufacturing an organic light emitting diode display according to the present disclosure.

### DETAILED DESCRIPTION OF THE ILLUSTRATED EMBODIMENTS

Referring to attached figures, we will explain preferred embodiments of the present disclosure. Like reference numerals designate like elements throughout the detailed description. However, the present disclosure is not restricted by these embodiments but can be applied to various changes or modifications without changing the technical spirit. In the following embodiments, the names of the elements are selected by considering the easiness for explanation so that they may be different from actual names.

The thin film transistor substrate for a flat panel display according to the present disclosure comprises a first thin film transistor disposed in a first area and a second thin film transistor disposed in a second area, on the same substrate. The substrate may include a display area and a non-display area. In the display area, a plurality of pixels is arrayed in a matrix. In one pixel area, the display elements are disposed. In the non-display area surrounding the display area, the driver elements for driving the display elements in the pixel area are disposed.

Here, the first area may be the non-display area, and the second area may be some portions or all portions of the display area. In this case, the first thin film transistor and the second thin film transistor are disposed as they may be apart from each other. Otherwise, the first area and the second area may be included in the display area. Especially, for the case that a plurality of thin film transistors are disposed in one pixel area, the first thin film transistor and the second thin film transistor may be closely disposed.

As the polycrystalline semiconductor material has the characteristics of high mobility (over 100 cm²/Vs) and of low energy consumption power, and it has high reliability, it is proper to apply to the driver IC, such as the gate driver for driving the display elements and/or the multiplexer (or 'MUX'). In addition, it can be applied to the driving thin film transistor disposed in the pixel area of the organic light emitting diode display. As the oxide semiconductor material has low off-current, it is proper to apply to the semiconductor layer of the switching thin film transistor in the pixel area, in which the ON time period is very short but the OFF time period is long. Further, as the off-current is low, the holding time of the pixel voltage may be long, so that the oxide semiconductor material is suitable for a display device requiring low frequency drive and/or low power consumption. By disposing these two different type thin film transistors on the same substrate, it can be obtained a thin film transistor substrate representing the optimal effect.

When there are some vacancies in the polycrystalline semiconductor layer, the characteristics of the semiconductor device would be degraded. The hydrogenation process would be required for filling the vacancies with the hydrogen particles, such as the hydrogen atoms or the hydrogen ions. On the contrary, for the case that the semiconductor device includes the oxide semiconductor material, the semiconductor device may be degraded when a lot of the hydrogen particles is diffused into the oxide semiconductor layer. Therefore, it is preferable that the oxide semiconductor layer is disposed as being apart from the polycrystalline semiconductor layer. To do so, in the structure of the thin film transistor substrate suggested by this application, the first thin film transistor including the oxide semiconductor material has the top gate structure, and the second thin film transistor including the polycrystalline semiconductor material has the bottom gate structure.

For hydrogenation process, a nitride layer including a lot of hydrogen particles is deposited over the polycrystalline semiconductor layer. As the source materials used for depositing the nitride layer have the plentiful of hydrogen particles, the nitride layer also includes a lot of amount of the hydrogen particles. During the thermal treatment of the hydrogenation process, the hydrogen particles are diffused into the polycrystalline semiconductor layer. As the results, the polycrystalline semiconductor layer may be stabilized. However, during this thermal treatment, much amount of the hydrogen particles should not be diffused into the oxide semiconductor layer. To prevent that a large amount of the hydrogen particles is diffused into the oxide semiconductor layer, an oxide layer may be disposed between the nitride layer and the oxide semiconductor layer. As the oxide semiconductor layer cannot be influenced by the hydrogen particles so much, it can be kept in stabilized condition.

Hereinafter, in convenience, we will explain about the thin film transistor substrate used for the organic light emitting diode display. In the preferred embodiment, the first thin film transistor and the second thin film transistor are disposed in the display area. Especially, the first thin film transistor including the polycrystalline semiconductor material is applied to the driving thin film transistor, and the second thin film transistor including the oxide semiconductor material is applied to the switching thin film transistor. However, it is not restricted in this case only. Another thin film transistor substrate for the other type flat panel displays may have alternative structure. For example, the first (polycrystalline) thin film transistor is applied to the driving thin film transistor disposed in the non-display area, and the second (oxide) thin film transistor is applied to the thin film transistor disposed in the display area.

### < Preferred Embodiment >

Hereinafter, referring to FIGs. 5 and 6, we will explain about a thin film transistor substrate including two different type thin film transistors on the same substrate according to one preferred embodiment of the present disclosure. FIG. 5 is a plane view illustrating a structure of one pixel in the organic light emitting diode display according to a preferred embodiment of the present disclosure. FIG. 6 is a cross sectional view along the cutting line of II-II' in FIG. 5 for illustrating the structure of an organic light emitting diode display according to the preferred embodiment of the present disclosure.

The thin film transistor substrate for an organic light emitting diode display according to one preferred embodiment of the present disclosure comprises a switching thin film transistor ST disposed on a substrate SUB, a driving thin film transistor DT connected to the switching thin film transistor ST, and an organic light emitting diode OLE connected to the driving thin film transistor DT. The switching thin film transistor ST is formed where the scan line SL and the data line DL is crossing. The switching thin film transistor ST acts for selecting the pixel which is connected to the switching thin film transistor ST. The switching thin film transistor ST includes a switching gate electrode SG branching from the scan line SL (or gate line GL), a switching semiconductor layer including channel area SA overlapping with the switching gate electrode SG, a switching source electrode SS and a switching drain electrode SD.

The driving thin film transistor DT acts for driving an anode electrode ANO of the organic light emitting diode OLE disposed at the pixel selected by the switching thin film transistor ST. The driving thin film transistor DT includes a driving gate electrode DG connected to the switching drain electrode SD of the switching thin film transistor ST, a driving semiconductor layer including channel area DA, a driving source electrode DS connected to the driving current line VDD, and a driving drain electrode DD. The driving drain electrode DD of the driving thin film transistor DT is connected to the anode electrode ANO of the organic light emitting diode OLE.

Now, with FIG. 6, we will explain about the cross sectional structure of the thin film transistor substrate for the organic light emitting diode display according to the preferred embodiment of the present disclosure, in detail. On a transparent substrate SUB, a buffer layer BUF is deposited as covering the whole surface of the substrate SUB. On the buffer layer BUF, a first (switching) semiconductor layer including an oxide semiconductor material is formed. The first (switching) semiconductor layer includes a switching channel area SA at the middle portion, and a switching source area (SSA) and a switching drain area (SDA) at both side portions, respectively.

On the first (switching) semiconductor layer, a first gate insulating layer GI1 is deposited as covering the whole surface of the substrate SUB. On the first gate insulating layer GI1, gate elements are formed. The gate elements include a switching gate electrode SG of the switching thin film transistor ST, a driving gate electrode DG of the driving thin film transistor DT, a first storage electrode ST1 extended from the driving gate electrode DG, and a scan line SL (or, gate line GL) connected to the switching gate electrode SG. The switching gate electrode SG is overlapped with the switching channel area SA, the middle portion of the first (switching) semiconductor layer, having the first gate insulating layer GI1 there-between.

On the gate elements SG, DG and ST1, a second gate insulating layer GI2 is deposied as covering the whole surface of the substrate SUB. On the second gate insulating layer GI2, a second (driving) semiconductor layer including a polycrystalline semiconductor material for the driving thin film transistor DT is formed. The second (driving) semiconductor layer includes a driving channel area DA at the middle portion, a driving source area DSA and a driving drain area DDA at both side portions, respectively, and a second storage electrode ST2.

The driving channel area DA of the second (driving) semiconductor layer is overlapped with the driving gate electrode DG having the second gate insulating layer GI2 there-between. One end portion of the driving drain area DDA of the second semiconductor layer is extended to and becoming as the second storage electrode ST2. The second storage electrode ST2 is overlapped with the first storage electrode ST1 having the second gate insulating layer GI2 there-between. A storage capacitance STG is formed at the overlapped portion of the second gate insulating layer GI2 disposed between the first storage electrode ST1 and the second storage electrode ST2.

On the second (driving) semiconductor layer, an intermediate insulating layer ILD is deposited as covering the whole surface of the substrate SUB. It is preferable that the intermediate insulating layer ILD includes an oxide layer SIO and a nitride layer SIN on the oxide layer SIO. The nitride layer SIN is for diffusion of the hydrogen particles into the driving channel area DA of the driving thin film transistor DT including the polycrystalline semiconductor material disposed there-under. The oxide layer SIO is for controlling the amount of the hydrogen particles diffused into the driving channel area DA of the driving thin film transistor DT. Therefore, the thickness of the oxide layer SIO may be varied according to the parameters or conditions of the hydrogenation process. For one case, the oxide layer SIO may not be formed. In that case, the thickness of the oxide layer SIO may be zero, and the intermediate insulating layer ILD may have the nitride layer SIN only.

Under the nitride layer SIN, there is not only the second (driving) semiconductor layer but also the first (switching) semiconductor layer including the oxide semiconductor material. Therefore, the hydrogen particles out of the nitride layer SIN may be also diffused into the first semiconductor layer. However, on the first semiconductor layer, the first gate insulating layer GI1 and the second gate insulating layer GI2 are stacked. It is preferable that these two gate insulating layers GI1 and GI2 are made of the oxide materials. Due to these two gate insulating layers GI1 and GI2, it is possible to prevent too much amount of the hydrogen particles from diffusing into the first semiconductor layer. As mentioned above, by controlling the thickness of the intermediate insulating layer ILD, the amount of the hydrogen particle diffused into the first semiconductor layer can be precisely and/or exactly controlled.

On the intermediate insulating layer ILD, source elements are formed. The source elements include a switching source electrode SS and a switching drain electrode SD of the switching thin film transistor ST, a driving source electrode DS and a driving drain electrode DD of the driving thin film transistor DT, a data line DL connected to the switching source electrode SS, and a driving current line VDD connected to the driving source electrode DS. The switching source electrode SS contacts the switching source area SSA via the switching source contact hole SSH penetrating the intermediate insulating layer ILD, the second gate insulating layer GI2 and the first gate insulating layer GI1.

In addition, the switching drain electrode SD contacts the switching drain area SDA via the switching drain contact hole SDH penetrating the intermediate insulating layer ILD, the second gate insulating layer GI2 and the first gate insulating layer GI1. Specially, the switching drain contact hole SDH exposes some portions of the driving gate electrode DG overlapped with some of the switching drain area SDA. The switching drain electrode SD contacts the switching drain area SDA and the driving gate electrode DG via the switching drain contact hole SDH, so the three electrodes are electrically connected each other. With one switching drain contact hole SDH only, two different elements are contacted and connected to the third element at the same time. Therefore, the number of the contact hole can be minimized. By reducing or minimizing the number of contact hole, the emitting area in the pixel area can be maximized.

The driving source electrode DS contacts the driving source area DSA via the driving source contact hole DSH penetrating the intermediate insulating layer ILD. The driving drain electrode DD contacts the driving drain area DDA via the driving drain contact hole DDH penetrating the intermediate insulating layer ILD. The driving source contact hole DSH and the driving drain contact hole DDH for the driving thin film transistor DT are formed at the same time with the switching source contact hole SSH and the switching drain contact hole SDH for the switching thin film transistor ST. At forming the switching source contact hole SSH and the switching drain contact hole SDH, the four layers including the intermediate insulating layer ILD, the second gate insulating layer GI2 and/or the first gate insulating layer GI1 are etched. At this time, the driving source contact hole DSH and the driving drain contact hole DDH are formed by penetrating the four layers including the intermediate insulating layer ILD, the second semiconductor layer, and the second gate insulating layer GI2. In that case, the driving source electrode DS may contact the etched side wall of the driving source area DSA, and the driving drain electrode DD may contact the etched side wall of the driving drain area DDA.

On the switching thin film transistor ST and the driving thin film transistor DT, a passivation layer or a planar layer OC is deposited as covering the whole surface of the substrate SUB. At the planar layer OC, a pixel contact hole PH exposing some of the driving drain electrode DD is formed. Here, it is preferable that the pixel contact hole PH is vertically overlapped with the driving drain contact hole DDH. By disposing two contact holes as being vertically overlapped, the size of plane area for contact holes is minimized or reduced. By reducing or minimizing the size of the contact holes, the emission area in the pixel area may be maximized or enlarged.

On the planar layer OC, an anode electrode ANO is formed. The anode electrode ANO contacts the driving drain electrode DD of the driving thin film transistor DT via the pixel contact hole PH. It is preferable that the anode electrode ANO is formed as having the maximum size in the pixel area defined and surrounded by the scan line SL, the data line DL and the driving current line VDD.

On the substrate SUB having the anode electrode ANO, a bank BN is formed. The bank BN has an aperture defining the emission area of the anode electrode ANO. On the substrate SUB having the bank BN, an organic light emitting layer OL and a cathode electrode CAT are sequentially stacked. An organic light emitting diode OLE including the anode electrode ANO, the organic light emitting layer OL and the cathode electrode CAT is connected to the driving thin film transistor DT.

Hereinafter referring to FIG. 7, we will explain about the method for manufacturing an organic light emitting diode display according to one preferred embodiment of the present disclosure. FIG. 7 is a flow chart illustrating a method for manufacturing an organic light emitting diode display according to the present disclosure.

In the step of S100, on a substrate SUB, a buffer layer BUF is deposited. Enven though not shown in figures, a light shielding layer may be formed at required positions, before depositing the buffer layer BUF.

In the step of S110, an oxide semiconductor material is deposited on the buffer layer BUF. The oxide semiconductor material may be selected at least any oene of an IGZO(Indium Gallium Zinc Oxide), IGO(Indium Gallium Oxide) and IZO(Indium Zinc Oxide). By patterning the oxide semiconductor layer with the first mask process, a first semiconductor layer is formed. The first semiconductor layer includes a switching channel area SA, a switching source area SSA and a switching drain area SDA of the switching thin film transistor ST.

In the step of S200, a first gate insulating layer GI1 is deposited on the substrate SUB having the first semiconductor layer. As the first gate insulating layer GI1 contacts the first semiconductor layer having the oxide semiconductor material, it is preferably made of an oxide insulating material such as the silicon oxide (SiOx).

In the step of S210, gate elements are formed by depositing a gate metal on the first gate insulating layer GI and patterning it with a second mask process. The gate elements includes a switching gate electrode SG of the switching thin film transistor ST, a driving gate electrode DG of the driving thin film transistor DT, a first storage electrode ST1, and a scan line SL. The switching gate electrode SG is disposed as being overlapped with the switching channel area SA.

In the step of S300, a second gate insulating layer GI2 is deposited on the substrate SUB having the gate elements. As the second gate insulating layer GI2 is disposed as close with the first semiconductor layer having the oxide semiconductor material, it is preferably made of the oxide insulating material such as silicon oxide (SiOx).

In the step of S310, an amorphous silicon (a-Si) layer is deposited on the second gate insulating layer GI2 and crystallization process is conducted to convert the amorphous silicon layer to a polycrystalline silicon layer, e.g. low temperature poly silicon (LTPS). By patterning the polycrystalline silicon layer with the third mask process, a second semiconductor layer is formed. The second semiconductor layer includes a driving channel area DDA, a driving source area DSA, a driving drain area DDA and a second storage electrode ST2 extended from the driving drain area DDA.

In the step of S400, an intermediate insulating layer ILD is deposited on the whole surface of the substrate SUB having the second semiconductor layer. It is preferable that the intermediate insulating layer ILD is formed by sequentially depositing or stacking an oxide layer SIO and a nitride layer SIN. However, as mentioned before, the intermediate insulating layer ILD may also include only the nitride layer SIN without an oxide layer SIO, i.e. the oxide layer SIO may be omitted in the intermediate insulating layer ILD.

In the step of S410, contact holes are formed by patterning the intermediate insulating layer ILD, the second semiconductor layer, the second gate insulating layer GI2 and/or the first gate insulating layer IG1 with the fourth mask process. The contact holes include a switching source contact hole SSH and a switching drain contact hole SDH exposing the switching source area SSA and the switching drain area SDA, respectively, and a driving source contact hole DSH and a driving drain contact hole DDH exposing the driving source area DSA and the driving drain area DDA, respectively. Here, the switching drain contact hole SDH exposing the switching drain area SDA is preferably formed as exposing some of the driving gate electrode DG.

In the step of S500, source elements are formed by depositing a source metal on the intermediate insulating layer ILD and then patterning it with the fifth mask process. The source elements includes a switching source electrode SS, a switching drain electrode SD, a driving source electrode DS and a driving drain electrode DD. The switching source electrode SS contacts the switching source area SSA via the switching source contact hole SSH. The switching drain electrode SD contact the switching drain area SDA via the switching drain contact hole SDH. The switching drain electrode SD contacts the switching drain area SDA and the driving gate electrode DG via the switching drain contact hole SDH. The driving source electrode DS contacts the driving source area DSA via the driving source contact hole DSH. The driving drain electrode DD contacts the driving drain area DDA via the driving drain contact hole DDH.

In the step of S600, a planar layer OC is deposited or coated on the whole surface of the substrate SUB having the switching thin film transistor ST and the drain thin film transistor DT. In some cases, a passivation layer and the planar layer OC may be sequentially deposited.

In the step of S610, by patterning the planar layer OC with the sixth mask process, a pixel contact hole PH is formed. The pixel contact hole PH exposes some of the driving drain electrode DD of the driving thin film transistor DT. The pixel contact hole PH is formed on the driving drain contact hole DDH so as to be vertically overlapped with the driving drain contact hole DDH.

In the step of S700, depositing an electrode material on the planar layer OC and then patterning it with the seventh mask process, an anode electrode ANO is formed. The anode electrode ANO contacts the driving drain electrode DD via the pixel contact hole PH.

In the step of S800, a bank BN is deposited on the substrate SUB having the anode electrode ANO. Patterning the bank BN with the eighth mask process, an aperture is formed as exposing the most portions of the anode electrode ANO.

In the step of S900, an organic light emitting layer OL and a cathode electrode CAT are sequentially deposited on the bank BN having the aperture. Then, at the aperture of the bank BN, an oranic light emitting diode OLE is formed as stacking the anode electrode ANO, the organic light emitting layer OL and the cathode electrode CAT.

In the step of S410 for forming the contact holes, the switching drain contact hole SDH is formed as exposing some portions of the switching drain area SDA with some portions of the driving gate electrode DG. That is, two different elements formed in different layers, respectively are exposed through one same contact hole, so the number of the contact hole can be reduced.

Further, in the step of S610 for forming the pixel contact hole PH, the pixel contact hole PH is formed on the driving drain contact hole DDH as being vertically overlapped each other. That is, two different contact holes are formed as being overlapped in the vertical structure. Therefore, with just one contact hole, the size for reserving the contact hole can be minimized.

The thin film transistor substrate according to a preferred embodiment of the present disclosure comprises the switching thin film transistor having the oxide semiconductor material with the top gate structure and the driving thin film transistor having the polycrystalline semiconductor material with the bottom gate structure. The present disclosure suggests the thin film transistor substrate optimized for the flat display panel. In addition, by minimizing the number of the contact holes and reducing the size of the contact hole, the emission area of the organic light emitting diode display can be enlarged and/or maximized. Consequently, the present disclosure suggests a high quality display having the ultra high density resolution, the large area and the lower energy consumption.

While the embodiment of the present invention has been described in detail with reference to the drawings, it will be understood by those skilled in the art that the invention can be implemented in other specific forms without changing the essential features of the invention. Therefore, it should be noted that the forgoing embodiments are merely illustrative in all aspects and are not to be construed as limiting the invention. The scope of the invention is defined by the appended claims rather than the detailed description of the invention. All changes or modifications or their equivalents made within the meanings and scope of the claims should be construed as falling within the scope of the invention.

## Claims

1. A thin film transistor substrate for an organic light emitting diode display, comprising:
a first thin film transistor (ST) including an oxide semiconductor layer, a first gate electrode (SG) on the oxide semiconductor layer, a first source electrode (SS) and a first drain electrode (SD);
a second thin film transistor (DT) including a second gate electrode (DG), a polycrystalline semiconductor layer on the second gate electrode (DG), a second source electrode (DS) and a second drain electrode (DD);
a first gate insulating layer (GI1) disposed between the first gate electrode (SG) and the oxide semiconductor layer;
a second gate insulating layer (GI2) disposed between the polycrystalline semiconductor layer and the second gate electrode (DG);
an intermediate insulating layer (ILD) disposed on the first gate electrode of the first thin film transistor (ST) and the polycrystalline semiconductor layer of the second thin film transistor (DT), the intermediate insulating layer (ILD) including a nitride layer (SIN) including hydrogen; and
a passivation layer (OC) covering the first thin film transistor (ST) and the second thin film transistor (DT).

2. The substrate according to the claim 1, wherein the intermediate insulating layer (ILD) further includes an oxide layer (SIO) disposed between the nitride layer (SIN) and the first gate electrode (SG) of the first thin film transistor (ST) as well as between the polycrystalline semiconductor layer of the second thin film transistor (DT) and the nitride layer (SIN).

3. The substrate according to the claim 1 or 2, wherein the second gate electrode (DG) overlaps a portion of a drain area (SDA) of the oxide semiconductor layer with the first gate insulating layer (GI1) disposed there-between.

4. The substrate according to any one of the preceding claims, wherein the first source electrode (SS) is disposed on the intermediate insulating layer (ILD), and is in contact with a source area (SSA) of the oxide semiconductor layer via a first source contact hole (SSH) penetrating the intermediate insulating layer (ILD), the second gate insulating layer (GI2) and the first gate insulating layer (GI1).

5. The substrate according to any one of the preceding claims, wherein the first drain electrode (SD) is disposed on the intermediate insulating layer (ILD), and is in contact with a drain area (SDA) of the oxide semiconductor layer via a first drain contact hole (SDH) penetrating the intermediate insulating layer (ILD), the second gate insulating layer (GI2) and the first gate insulating layer (GI1), particularly wherein the first drain contact hole (SDH) exposes some portions of the second gate electrode (DG) overlapping the drain area (SDA) of the oxide semiconductor layer, and the first drain electrode (SD) electrically contacts the second gate electrode (DG) via the first drain contact hole (SDH).

6. The substrate according to any one of the preceding claims, wherein the second source electrode (DS) is disposed on the intermediate insulating layer (ILD), and is in contact with a source area (DSA) of the polycrystalline semiconductor layer via a second source contact hole (DSH) penetrating the intermediate insulating layer (ILD), the polycrystalline semiconductor layer and the second gate insulating layer (GI2).

7. The substrate according to any one of the preceding claims, wherein the second drain electrode (DD) is disposed on the intermediate insulating layer (ILD), and is in contact with a drain area (DDA) of the polycrystalline semiconductor layer via a second drain contact hole (DDH) penetrating the intermediate insulating layer (ILD), the polycrystalline semiconductor layer and the second gate insulating layer (GI2).

8. The substrate according to any one of the preceding claims 6 or 7, wherein the source area (DSA) and/or the drain area (DDA) include an etched wall of the polycrystalline semiconductor layer.

9. The substrate according to any one of the preceding claims, wherein the first thin film transistor (ST) is a switching element for selecting a pixel of the thin film transistor substrate, and
wherein the second thin film transistor (DT) is a driving element for driving an organic light emitting diode (OLE) disposed in the pixel selected by the first thin film transistor (ST).

10. The substrate according to any one of the preceding claims, further comprising:
a pixel contact hole (PH) formed in the passivation layer (OC), and exposing the second drain electrode (DD); and
an anode electrode (ANO) disposed on the passivation layer (OC), and connected to the second drain electrode (DD) via the pixel contact hole (PH).

11. The substrate according to any one of the preceding claims, further comprising:
a bank (BN) defining an aperture area exposing an emitting area of the anode electrode (ANO);
an organic light emitting layer (OL) disposed on the bank (BN), and contacting the anode electrode (ANO) in the aperture area; and
a cathode electrode (CAT) disposed on the organic light emitting layer (OL).

12. An organic light emitting diode display including a substrate according to any one of the preceding claims.

13. A method for manufacturing a thin film transistor substrate for an organic light emitting diode display, the method including the steps of:
forming (S110) an oxide semiconductor layer on a substrate (SUB);
forming (S200) a first gate insulating layer (GI1) on the oxide semiconductor layer;
forming (S210) a first gate electrode (SG) of a first thin film transistor (ST) and a second gate electrode (DG) of a second thin film transistor (DT) on the first gate insulating layer (GI1), the first gate electrode (SG) being disposed overlapping with the oxide semiconductor layer;
forming (S300) a second gate insulating layer (GI2) on the first gate electrode (SG) and the second gate electrode (DG);
forming (S310) a polycrystalline semiconductor layer on the second gate insulating layer (GI2), the polycrystalline semiconductor layer being disposed overlapping with the second gate electrode (DG);
forming (S400) an intermediate insulating layer (ILD) including a nitride layer (SIN) including hydrogen
on the polycrystalline semiconductor layer and on the second gate insulating layer (GI2);
forming (S500) first and second source electrodes (SS, DS) and first and second drain electrodes (SD, DD) on the intermediate insulating layer (ILD), whereby the first thin film transistor (ST) including the oxide semiconductor layer, the first gate electrode (SG) on the oxide semiconductor layer, the first source electrode (SS) and the first drain electrode (SD), and the second thin film transistor (DT) including the second gate electrode (DG), the polycrystalline semiconductor layer on the second gate electrode (DG), the second source electrode (DS) and the second drain electrode (DD) are formed; and
forming (S600) a passivation layer (OC) on the first thin film transistor (ST) and the second thin film transistor (DT).

14. The method of claim 13, further comprising the step of forming (S410) at least one contact hole including at least one of:
a first source contact hole (SSH) penetrating the intermediate insulating layer (ILD), the second gate insulating layer (GI2) and the first gate insulating layer (GI1) for connecting the first source electrode (SS) and a source area (SSA) of the oxide semiconductor layer;
a first drain contact hole (SDH) penetrating the intermediate insulating layer (ILD), the second gate insulating layer (GI2) and the first gate insulating layer (GI1) for connecting the first drain electrode (SD), a drain area (SDA) of the oxide semiconductor layer and the second gate electrode (DG); and
a second source contact hole (DSH) penetrating the intermediate insulating layer (ILD), the polycrystalline semiconductor layer and the second gate insulating layer (GI2) for connecting the second source electrode (DS) and a source area (DSA) of the polycrystalline semiconductor layer.

15. The method of claim 13 or 14, further comprising the steps of:
forming (S410) a second drain contact hole (DDH) penetrating the intermediate insulating layer (ILD), the polycrystalline semiconductor layer and the second gate insulating layer (GI2) for connecting the second drain electrode (DD) and a drain area (DDA) of the polycrystalline semiconductor layer;
forming (S600) the passivation layer (OC) on the first and second source electrode (SS, DS) and on the first and second drain electrode (SD, DD); and
forming (S610) a pixel contact hole (PH) in the passivation layer (OC) disposed in the second drain contact hole (DDH) for exposing the second drain electrode (DD).

## Patentansprüche

1. Dünnschichttransistorsubstrat für eine organische lichtemittierende Diodenanzeige, umfassend:
einen ersten Dünnschichttransistor (ST), der eine Oxidhalbleiterschicht, eine erste Gate-Elektrode (SG) auf der Oxidhalbleiterschicht, eine erste Source-Elektrode (SS) und eine erste Drain-Elektrode (SD) umfasst;
einen zweiten Dünnschichttransistor (DT), der eine zweite Gate-Elektrode (DG), eine polykristalline Halbleiterschicht auf der zweiten Gate-Elektrode (DG), eine zweite Source-Elektrode (DS) und eine zweite Drain-Elektrode (DD) umfasst;
eine erste Gate-Isolierschicht (GI1), die zwischen der erste Gate-Elektrode (SG) und der Oxidhalbleiterschicht angeordnet ist;
eine zweite Gate-Isolierschicht (GI2), die zwischen der polykristallinen Halbleiterschicht und der zweiten Gate-Elektrode (DG) angeordnet ist;
eine Zwischenisolierschicht (ILD), die auf der ersten Gate-Elektrode des ersten Dünnschichttransistors (ST) und der polykristallinen Halbleiterschicht des zweiten Dünnschichttransistors (DT) angeordnet ist, wobei die Zwischenisolierschicht (ILD) eine Wasserstoff umfassende Nitridschicht (SIN) umfasst; und
eine Passivierungsschicht (OC), die den ersten Dünnschichttransistor (ST) und den zweiten Dünnschichttransistor (DT) bedeckt.

2. Substrat nach Anspruch 1, wobei die Zwischenisolierschicht (ILD) ferner eine Oxidschicht (SIO) umfasst, die zwischen der Nitridschicht (SIN) und der ersten Gate-Elektrode (SG) des ersten Dünnschichttransistors (ST) sowie zwischen der polykristallinen Halbleiterschicht des zweiten Dünnschichttransistors (DT) und der Nitridschicht (SIN) angeordnet ist.

3. Substrat nach einem der Ansprüche 1 oder 2, wobei die zweite Gate-Elektrode (DG) mit einem Abschnitt des Drain-Bereichs (SDA) der Oxidhalbleiterschicht überlappt, wobei die erste Gate-Isolierschicht (GI1) dazwischen angeordnet ist.

4. Substrat nach einem der vorhergehenden Ansprüche, wobei die erste Source-Elektrode (SS) auf der Zwischenisolierschicht (ILD) angeordnet ist und in Kontakt mit einem Source-Bereich (SSA) der Oxidhalbleiterschicht über ein erstes Source-Kontaktloch (SSH) ist, das die Zwischenisolierschicht (ILD), die zweite Gate-Isolierschicht (GI2) und die erste Gate-Isolierschicht (GI1) durchdringt.

5. Substrat nach einem der vorhergehenden Ansprüche, wobei die erste Drain-Elektrode (SD) auf der Zwischenisolierschicht (ILD) angeordnet ist und in Kontakt mit einem Drain-Bereich (SDA) der Oxidhalbleiterschicht über ein erstes Drain-Kontaktloch (SDH) ist, das die Zwischenisolierschicht (ILD), die zweite Gate-Isolierschicht (GI2) und die erste Gate-Isolierschicht (GI1) durchdringt, insbesondere wobei das erste Drain-Kontaktloch (SDH) einige Abschnitte der zweiten Gate-Elektrode (DG) freilegt, die mit dem Drain-Bereich (SDA) der Oxidhalbleiterschicht überlappen, und die erste Drain-Elektrode (SD) mit der zweiten Gate-Elektrode (DG) über das erste Drain-Kontaktloch (SDH) elektrisch in Kontakt ist.

6. Substrat nach einem der vorhergehenden Ansprüche, wobei die zweite Source-Elektrode (DS) auf der Zwischenisolierschicht (ILD) angeordnet ist und in Kontakt mit einem Source-Bereich (DSA) der polykristallinen Halbleiterschicht über ein zweites Source-Kontaktloch (DSH) ist, das die Zwischenisolierschicht (ILD), die polykristalline Halbleiterschicht und die zweite Gate-Isolierschicht (GI2) durchdringt.

7. Substrat nach einem der vorhergehenden Ansprüche, wobei die zweite Drain-Elektrode (DD) auf der Zwischenisolierschicht (ILD) angeordnet ist und in Kontakt mit einem Drain-Bereich (DDA) der polykristallinen Halbleiterschicht über ein zweites Drain-Kontaktloch (DDH) ist, das die Zwischenisolierschicht (ILD), die polykristalline Halbleiterschicht und die zweite Gate-Isolierschicht (GI2) durchdringt.

8. Substrat nach einem der vorhergehenden Ansprüche 6 oder 7, wobei der Source-Bereich (DSA) und/oder der Drain-Bereich (DDA) eine geätzte Wand der polykristallinen Halbleiterschicht umfasst.

9. Substrat nach einem der vorhergehenden Ansprüche, wobei der erste Dünnschichttransistor (ST) ein Schaltelement zum Auswählen eines Pixels des Dünnschichttransistorsubstrats ist, und
wobei der zweite Dünnschichttransistor (DT) ein Ansteuerelement zum Ansteuern einer organischen lichtemittierenden Diode (OEL) ist, die in dem Pixel angeordnet ist, das vom ersten Dünnschichttransistor (ST) ausgewählt wurde.

10. Substrat nach einem der vorhergehenden Ansprüche, ferner umfassend:
ein Pixel-Kontaktloch (PH), das in der Passivierungsschicht (OC) ausgebildet ist und die zweite Drain-Elektrode (DD) freilegt; und
eine Anodenelektrode (ANO), die auf der Passivierungsschicht (OC) angeordnet und mit der zweiten Drain-Elektrode (DD) über das Pixel-Kontaktloch (PH) verbunden ist.

11. Substrat nach einem der vorhergehenden Ansprüche, ferner umfassend:
eine Bank (BN), die einen Öffnungsbereich bestimmt, der einen emittierenden Bereich der Anodenelektrode (ANO) freilegt;
eine organische lichtemittierende Schicht (OL), die auf der Bank (BN) angeordnet und in Kontakt mit der Anodenelektrode (ANO) im Öffnungsbereich ist; und
eine Kathodenelektrode (CAT), die auf der organischen lichtemittierenden Schicht (OL) angeordnet ist.

12. Organische lichtemittierende Diodenanzeige, die ein Substrat nach einem der vorhergehenden Ansprüche umfasst.

13. Verfahren zum Herstellen eines Dünnschichttransistorsubstrat für eine organische lichtemittierende Diodenanzeige, das Verfahren die folgenden Schritte umfassend:
Ausbilden (S110) einer Oxidhalbleiterschicht auf einen Substrat (SUB);
Ausbilden (S200) einer ersten Gate-Isolierschicht (GI1) auf der Oxidhalbleiterschicht;
Ausbilden (S210) einer ersten Gate-Elektrode (SG) eines ersten Dünnschichttransistors (ST) und einer zweiten Gate-Elektrode (DG) eines zweiten Dünnschichttransistors (DT) auf der ersten Gate-Isolierschicht (GI1), wobei die erste Gate-Elektrode (SG) überlappend mit der Oxidhalbleiterschicht angeordnet ist;
Ausbilden (S300) einer zweiten Gate-Isolierschicht (GI2) auf der ersten Gate-Elektrode (SG) und der zweiten Gate-Elektrode (DG);
Ausbilden (S310) einer polykristallinen Halbleiterschicht auf der zweiten Gate-Isolierschicht (GI2), wobei die polykristalline Halbleiterschicht überlappend mit der zweiten Gate-Elektrode (DG) angeordnet ist;
Ausbilden (S400) einer Zwischenisolierschicht (ILD), die eine Wasserstoff umfassende Nitridschicht (SIN) umfasst, auf der polykristallinen Halbleiterschicht und auf der zweiten Gate-Isolierschicht (GI2);
Ausbilden (S500) erster und zweiter Source-Elektroden (SS, DS) und erster und zweiter Drain-Elektroden (SD, DD) auf der Zwischenisolierschicht (ILD), wobei der erste Dünnschichttransistor (ST), der die Oxidhalbleiterschicht, die erste Gate-Elektrode (SG) auf der Oxidhalbleiterschicht, die erste Source-Elektrode (SS) und die erste Drain-Elektrode (SD) umfasst, und der zweite Dünnschichttransistor (DT) ausgebildet werden, der die zweite Gate-Elektrode (DG), die polykristalline Halbleiterschicht auf der zweiten Gate-Elektrode (DG), die zweite Source-Elektrode (DS) und die zweite Drain-Elektrode (DD) umfasst; und
Ausbilden (S600) einer Passivierungsschicht (OC) auf dem ersten Dünnschichttransistor (ST) und dem zweiten Dünnschichttransistor (DT).

14. Verfahren nach Anspruch 13, das ferner den Schritt des Ausbildens (S410) von mindestens einem Kontaktloch umfasst, das mindestens eines aus:
einem ersten Source-Kontaktloch (SSH), das die Zwischenisolierschicht (ILD), die zweite Gate-Isolierschicht (GI2) und die erste Gate-Isolierschicht (GI1) zum Verbinden der ersten Source-Elektrode (SS) mit einem Source-Bereich (SSA) der Oxidhalbleiterschicht durchdringt;
einem ersten Drain-Kontaktloch (SDH), das die Zwischenisolierschicht (ILD), die zweite Gate-Isolierschicht (GI2) und die erste Gate-Isolierschicht (GI1) durchdringt, um die erste Drain-Elektrode (SD), einen Drain-Bereich (SDA) der Oxidhalbleiterschicht und die zweite Gate-Elektrode (DG) zu verbinden; und
einem zweiten Source-Kontaktloch (DSH) umfasst, das die Zwischenisolierschicht (ILD), die polykristalline Halbleiterschicht und die zweite Gate-Isolierschicht (GI2) durchdringt, um die zweite Source-Elektrode (DS) und einen Source-Bereich (DSA) der polykristallinen Halbleiterschicht zu verbinden.

15. Verfahren nach Anspruch 13 oder 14, ferner die folgenden Schritte umfassend:
Ausbilden (S410) eines zweiten Drain-Kontaktlochs (DDH), das die Zwischenisolierschicht (ILD), die polykristalline Halbleiterschicht und die zweite Gate-Isolierschicht (GI2) durchdringt, um die zweite Drain-Elektrode (DD) und einen Drain-Bereich (DDA) der polykristallinen Halbleiterschicht zu verbinden;
Ausbilden (S600) der Passivierungsschicht (OC) auf der ersten und zweiten Source-Elektrode (SS, DS) und auf der ersten und zweiten Drain-Elektrode (SD, DD); und
Ausbilden (S610) eines Pixel-Kontaktlochs (PH) in der Passivierungsschicht (OC), das im zweiten Drain-Kontaktloch (DDH) zum Freilegen der zweiten Drain-Elektrode (DD) angeordnet ist.

## Revendications

1. Substrat de transistor à film mince pour un dispositif d'affichage à diodes électroluminescentes organiques, comprenant :
un premier transistor à film mince (ST) comprenant une couche semi-conductrice d'oxyde, une première électrode de grille (SG) sur la couche semi-conductrice d'oxyde, une première électrode de source (SS) et une première électrode de drain (SD) ;
un second transistor à film mince (DT) comprenant une seconde électrode de grille (DG), une couche semi-conductrice polycristalline sur la seconde électrode de grille (DG), une seconde électrode de source (DS) et une seconde électrode de drain (DD) ;
une première couche d'isolation de grille (GI1) disposée entre la première électrode de grille (SG) et la couche semi-conductrice d'oxyde ;
une seconde couche d'isolation de grille (GI2) disposée entre la couche semi-conductrice polycristalline et la seconde électrode de grille (DG) ;
une couche d'isolation intermédiaire (ILD) disposée sur la première électrode de grille du premier transistor à film mince (ST) et la couche semi-conductrice polycristalline du second transistor à film mince (DT), la couche d'isolation intermédiaire (ILD) ayant une couche de nitrure (SIN) comprenant de l'hydrogène ; et
une couche de passivation (OC) recouvrant le premier transistor à film mince (ST) et le second transistor à film mince (DT).

2. Substrat selon la revendication 1, dans lequel la couche d'isolation intermédiaire (ILD) comprend en outre une couche d'oxyde (SIO) disposée entre la couche de nitrure (SIN) et la première électrode de grille (SG) du premier transistor à film mince (ST), ainsi qu'entre la couche semi-conductrice polycristalline du second transistor à film mince (DT) et la couche de nitrure (SIN).

3. Substrat selon la revendication 1 ou 2, dans lequel la seconde électrode de grille (DG) chevauche une partie d'une zone de drain (SDA) de la couche semi-conductrice d'oxyde avec la première couche d'isolation de grille (GI1) disposée entre elles.

4. Substrat selon l'une quelconque des revendications précédentes, dans lequel la première électrode de source (SS) est disposée sur la couche d'isolation intermédiaire (ILD) et est en contact avec une zone de source (SSA) de la couche semi-conductrice d'oxyde par l'intermédiaire d'un premier trou de contact de source (SSH) pénétrant dans la couche d'isolation intermédiaire (ILD), la seconde couche d'isolation de grille (GI2) et la première couche d'isolation de grille (GI1).

5. Substrat selon l'une quelconque des revendications précédentes, dans lequel la première électrode de drain (SD) est disposée sur la couche d'isolation intermédiaire (ILD) et est en contact avec une zone de drain (SDA) de la couche semi-conductrice d'oxyde par l'intermédiaire d'un premier trou de contact de drain (SDH) pénétrant dans la couche d'isolation intermédiaire (ILD), la seconde couche d'isolation de grille (GI2) et la première couche d'isolation de grille (GI1), en particulier le premier trou de contact de drain (SDH) exposant certaines parties de la seconde électrode de grille (DG) chevauchant la zone de drain (SDA) de la couche semi-conductrice d'oxyde, et la première électrode de drain (SD) étant électriquement en contact avec la seconde électrode de grille (DG) par l'intermédiaire du premier trou de contact de drain (SDH).

6. Substrat selon l'une quelconque des revendications précédentes, dans lequel la seconde électrode de source (DS) est disposée sur la couche d'isolation intermédiaire (ILD) et est en contact avec une zone de source (DSA) de la couche semi-conductrice polycristalline par l'intermédiaire d'un second trou de contact de source (DSH) pénétrant dans la couche d'isolation intermédiaire (ILD), la couche semi-conductrice polycristalline et la seconde couche d'isolation de grille (GI2).

7. Substrat selon l'une quelconque des revendications précédentes, dans lequel la seconde électrode de drain (DD) est disposée sur la couche d'isolation intermédiaire (ILD) et est en contact avec une zone de drain (DDA) de la couche semi-conductrice polycristalline par l'intermédiaire d'un second trou de contact de drain (DDH) pénétrant dans la couche d'isolation intermédiaire (ILD), la couche semi-conductrice polycristalline et la seconde couche d'isolation de grille (GI2).

8. Substrat selon l'une quelconque des revendications 6 ou 7, dans lequel la zone de source (DSA) et/ou la zone de drain (DDA) comprennent une paroi gravée de la couche semi-conductrice polycristalline.

9. Substrat selon l'une quelconque des revendications précédentes, dans lequel le premier transistor à film mince (ST) est un élément de commutation pour sélectionner un pixel du substrat de transistor à film mince, et
le second transistor à film mince (DT) est un élément de commande pour commander une diode électroluminescente organique (OLE) disposée dans le pixel sélectionné par le premier transistor à film mince (ST).

10. Substrat selon l'une quelconque des revendications précédentes, comprenant en outre :
un trou de contact de pixel (PH) formé dans la couche de passivation (OC) et exposant la seconde électrode de drain (DD) ; et
une électrode d'anode (ANO) disposée sur la couche de passivation (OC) et connectée à la seconde électrode de drain (DD) par l'intermédiaire du trou de contact de pixel (PH).

11. Substrat selon l'une quelconque des revendications précédentes, comprenant en outre :
un banc (BN) définissant une zone d'ouverture exposant une zone d'émission de l'électrode d'anode (ANO) ;
une couche électroluminescente organique (OL) disposée sur le banc (BN) et en contact avec l'électrode d'anode (ANO) dans la zone d'ouverture ; et
une électrode de cathode (CAT) disposée sur la couche électroluminescente organique (OL).

12. Dispositif d'affichage à diodes électroluminescentes organiques comprenant un substrat selon l'une quelconque des revendications précédentes.

13. Procédé de fabrication d'un substrat de transistor à film mince pour un dispositif d'affichage à diodes électroluminescentes organiques, le procédé comprenant les étapes :
former (S110) une couche semi-conductrice d'oxyde sur un substrat (SUB) ;
former (S200) une première couche d'isolation de grille (GI1) sur la couche semi-conductrice d'oxyde ;
former (S210) une première électrode de grille (SG) d'un premier transistor à film mince (ST) et une seconde électrode de grille (DG) d'un second transistor à film mince (DT) sur la première couche d'isolation de grille (GI1), la première électrode de grille (SG) étant disposée chevauchant la couche semi-conductrice d'oxyde ;
former (S300) une seconde couche d'isolation de grille (GI2) sur la première électrode de grille (SG) et la seconde électrode de grille (DG) ;
former (S310) une couche semi-conductrice polycristalline sur la seconde couche d'isolation de grille (GI2), la couche semi-conductrice polycristalline étant disposée chevauchant la seconde électrode de grille (DG) ;
former (S400) une couche d'isolation intermédiaire (ILD) ayant une couche de nitrure (SIN) comprenant de l'hydrogène sur la couche semi-conductrice polycristalline et sur la seconde couche d'isolation de grille (GI2) ;
former (S500) des première et seconde électrodes de source (SS, DS) et des première et seconde électrodes de drain (SD, DD) sur la couche d'isolation intermédiaire (ILD), ce par quoi le premier transistor à film mince (ST) comprenant la couche semi-conductrice d'oxyde, la première électrode de grille (SG) sur la couche semi-conductrice d'oxyde, la première électrode de source (SS) et la première électrode de drain (SD), et le second transistor à film mince (DT) comprenant la seconde électrode de grille (DG), la couche semi-conductrice polycristalline sur la seconde électrode de grille (DG), la seconde électrode de source (DS) et la seconde électrode de drain (DD), sont formés ; et
former (S600) une couche de passivation (OC) sur le premier transistor à film mince (ST) et le second transistor à film mince (DT).

14. Procédé selon la revendication 13, comprenant en outre l'étape de formation (S410) d'au moins un trou de contact comportant au moins un parmi :
un premier trou de contact de source (SSH) pénétrant dans la couche d'isolation intermédiaire (ILD), la seconde couche d'isolation de grille (GI2) et la première couche d'isolation de grille (GI1) pour connecter la première électrode de source (SS) et une zone de source (SSA) de la couche semi-conductrice d'oxyde ;
un premier trou de contact de drain (SDH) pénétrant dans la couche d'isolation intermédiaire (ILD), la seconde couche d'isolation de grille (GI2) et la première couche d'isolation de grille (GI1) pour connecter la première électrode de drain (SD), une zone de drain (SDA) de la couche semi-conductrice d'oxyde et la seconde électrode de grille (DG) ; et
un second trou de contact de source (DSH) pénétrant dans la couche d'isolation intermédiaire (ILD), la couche semi-conductrice polycristalline et la seconde couche d'isolation de grille (GI2) pour connecter la seconde électrode de source (DS) et une zone de source (DSA) de la couche semi-conductrice polycristalline.

15. Procédé selon la revendication 13 ou 14, comprenant en outre les étapes :
former (S410) un second trou de contact de drain (DDH) pénétrant dans la couche d'isolation intermédiaire (ILD), la couche semi-conductrice polycristalline et la seconde couche d'isolation de grille (GI2) pour connecter la seconde électrode de drain (DD) et une zone de drain (DDA) de la couche semi-conductrice polycristalline ;
former (S600) la couche de passivation (OC) sur les première et seconde électrodes de source (SS, DS) et sur les première et seconde électrodes de drain (SD, DD) ; et
former (S610) un trou de contact de pixel (PH) dans la couche de passivation (OC) disposée dans le second trou de contact de drain (DDH) pour exposer la seconde électrode de drain (DD).
